(19) Europäisches Patentamt
European Patent Office
Office européen des brevets

(11) **EP 0 714 139 B1**

(12) **FASCICULE DE BREVET EUROPEEN**

(45) Date de publication et mention
de la délivrance du brevet:
**12.10.2005 Bulletin 2005/41**

(51) Int Cl.⁷: **H01L 29/74**, H01L 29/747

(21) Numéro de dépôt: **95410131.7**

(22) Date de dépôt: **23.11.1995**

(54) **Composant dipôle à déclenchement par retounement à sensibilité contrôlée**

Zweipoliges Bauteil zur Überkopfzündung mit kontrollierter Empfindlichkeit

Break-over triggered two-terminal device with controlled sensitivity

(84) Etats contractants désignés:
**DE FR GB IT**

(30) Priorité: **25.11.1994 FR 9414415**

(43) Date de publication de la demande:
**29.05.1996 Bulletin 1996/22**

(73) Titulaire: **STMicroelectronics S.A.**
**92120 Montrouge (FR)**

(72) Inventeur: **Bernier, Eric**
**F-37390 Mettray (FR)**

(74) Mandataire: **de Beaumont, Michel**
**1bis, rue Champollion**
**38000 Grenoble (FR)**

(56) Documents cités:
**FR-A- 2 412 169**      **GB-A- 2 069 255**

- **PATENT ABSTRACTS OF JAPAN vol. 5 no. 149 (E-75) [821] ,19 Septembre 1981 & JP-A-56 081970 (MITSUBISHI DENKI K.K.) 4 Juillet 1981,**
- **PATENT ABSTRACTS OF JAPAN vol. 5 no. 117 (E-67) ,28 Juillet 1981 & JP-A-56 055068 (HITACHI LTD) 15 Mai 1981,**
- **IEEE TRANSACTIONS ON ELECTRON DEVICES, vol. 31, no. 11, Novembre 1984 pages 1570-1591, MICHAEL S. ADLER ET AL. 'The Evolution of Power Device Technology'**
- **PATENT ABSTRACTS OF JAPAN vol. 5 no. 95 (E-62) [767] ,20 Juin 1981 & JP-A-56 040277 (FUJI DENKI SEIZO K.K.) 16 Avril 1981,**
- **PATENT ABSTRACTS OF JAPAN vol. 9 no. 85 (E-308) [1808] ,13 Avril 1985 & JP-A-59 217366 (TOSHIBA K.K.) 7 Décembre 1984,**

EP 0 714 139 B1

**Description**

La présente invention concerne un composant dipôle à déclenchement par retournement en tension, c'est-à-dire un composant ayant la fonction d'une diode de Shockley qui devient passant quand la tension à ses bornes dépasse un seuil prédéterminé. La présente invention plus particulièrement un tel composant à sensibilité en retournement contrôlée, c'est-à-dire dont la tension et le courant de retournement peuvent être déterminés avec précision à la fabrication. On cherche en particulier à prévoir un tel composant dans lequel le courant de retournement soit faible mais qui reste peu sensible aux déclenchements parasites liés à des fronts de tension (déclenchement en dV/dt).

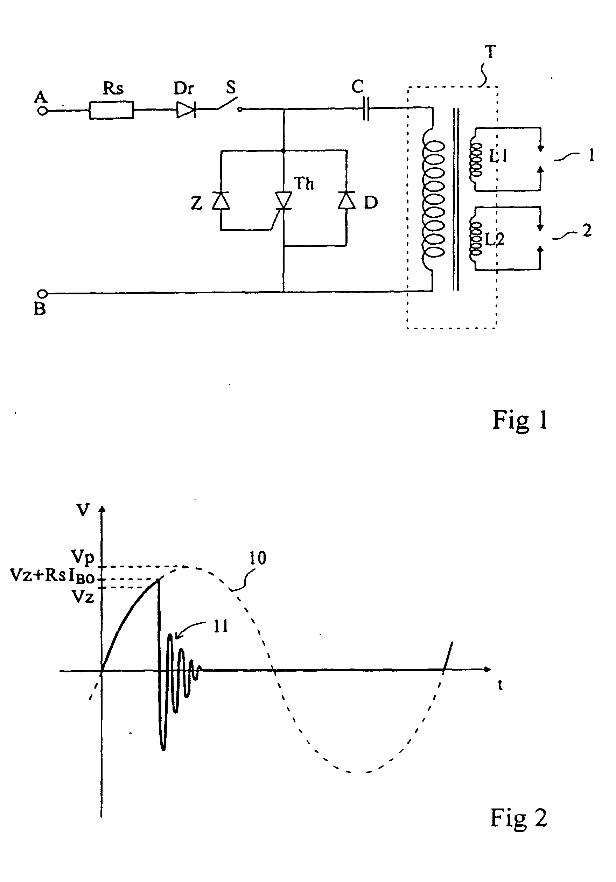

Un tel composant est par exemple utile dans un circuit d'allume-gaz tel que celui illustré en figure 1. Ce circuit comprend entre des bornes d'alimentation A et B, correspondant par exemple à la tension alternative du secteur à 220 volts, 50 Hz, une résistance Rs, une diode de redressement Dr, un interrupteur S, un condensateur C et le primaire d'un transformateur haute fréquence T. Le secondaire du transformateur comprend des enroulements L1 et L2 respectivement connectés à des éclateurs 1 et 2, par exemple destinés à deux feux d'une cuisinière à gaz. Entre la borne d'entrée du condensateur C et la borne B est disposé un circuit comprenant un thyristor Th, en antiparallèle avec une diode D. Entre la gâchette et l'anode du thyristor Th, est disposée une diode à avalanche Z.

Le fonctionnement de ce circuit va être exposé en relation avec la figure 2. Dans cette figure, la courbe 10 représente la tension entre les bornes A et B qui est une tension alternative de valeur de crête Vp. Une fois que le commutateur S est fermé, au début d'une alternance positive, le condensateur C commence à se charger jusqu'à ce que l'on atteigne la tension d'avalanche VZ de la diode à avalanche Z. Alors, un courant tend à circuler dans la jonction gâchette-cathode du thyristor Th. Quand ce courant atteint une valeur $I_{BO}$, le thyristor Th entre en conduction dans un état de faible impédance et le condensateur C se décharge dans le thyristor Th puis à travers la diode D et il se produit un courant oscillant à haute fréquence de décharge du condensateur C dans le thyristor Th puis dans la diode en antiparallèle D. Cette oscillation est convertie par le transformateur vers les enroulements L1 et L2 ce qui provoque l'apparition d'étincelles dans les éclateurs 1 et 2.

Ce circuit impose des conditions sévères d'amorçage du thyristor Th. En effet, une fois que la tension d'avalanche VZ de la diode Z est atteinte, il faut qu'un courant $I_{BO}$ suffisant pour amorcer ce thyristor Th puisse circuler. Ce courant $I_{BO}$ est fourni par la tension d'alimentation redressée et la valeur maximale de ce courant est fixée par la relation :

$$Rs I_{BO(MAX)} = Vp\text{-}VZ,$$

où Vp désigne la valeur de crête de la tension entre les bornes A et B. En pratique, la tension VZ est imposée pour avoir une tension de décharge suffisante et la résistance RS maximum admissible doit être relativement élevée pour permettre de sélectionner une durée longue entre deux étincelles.

En supposant que Rs=10 kiloohms, que la tension crête Vp entre les bornes A et B est de 300 volts, et que VZ=250 V, on obtient :

$$I_{BO(MAX)} = (300\text{-}250)/10\,000 = 5 \text{ mA}.$$

En pratique, ce courant d'amorçage est très faible pour un thyristor. En effet un thyristor usuel supportant une tension de 400 volts a un courant d'amorçage $I_{BO}$ de quelques dizaines de milliampères. Une autre difficulté est que la tension VZ de la diode à avalanche Z doit être fixée avec précision pour que cette valeur $I_{BO(MAX)}$ ne soit pas trop variable et que la plage de déclenchement ne soit pas encore réduite.

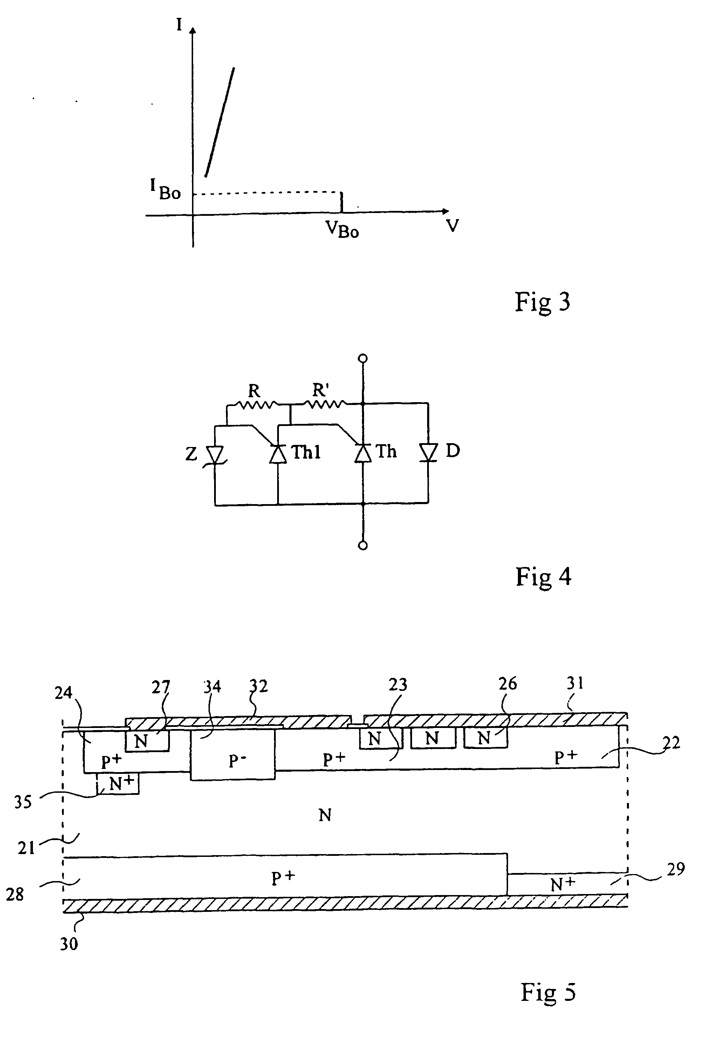

La figure 3 représente la courbe tension-courant d'un thyristor actionné par retournement en tension. Quand la tension $V_{BO}$ (la tension VZ de la diode à avalanche) est atteinte, le courant dans le thyristor commence à croître puis la tension aux bornes du thyristor chute brutalement tandis que le thyristor devient passant dès que le courant dans ce thyristor a atteint une valeur $I_{BO}$. On cherche donc à former un composant dipôle du type thyristor ayant d'une part une valeur de $I_{BO}$ faible, d'autre part une valeur de $V_{BO}$ (VZ) bien déterminée.

La figure 4 représente un circuit classique de composant dipôle à déclenchement par retournement en tension comprenant un thyristor à amplification de gâchette permettant d'atteindre cette fonction. Le thyristor Th est associé à un thyristor pilote Th1. Les anodes des thyristors Th et Th1 sont interconnectées, la cathode du thyristor Th1 est reliée à la gâchette du thyristor Th par l'intermédiaire d'une résistance R. La diode de déclenchement Z est disposée entre anode et gâchette du thyristor Th1. La résistance gâchette-cathode du thyristor Th est désignée par R'.

Des techniques sont connues pour réaliser un thyristor Th1 très sensible mais cela impose d'utiliser entre cathode et gâchette une résistance R de valeur non négligeable (de l'ordre de 1 à 10 kohms) pour éviter que le thyristor Th1 ne se déclenche lors d'apparition de parasites sur l'alimentation, c'est-à-dire par un déclenchement en dV/dt.

Une réalisation classique sous forme de composant monolithique du circuit de la figure 4 est illustrée en figure 5. Ce composant est réalisé à partir d'un substrat de type N faiblement dopé 21. Dans la face supérieure du substrat, des régions 22, 23 et 24 de type P correspondent respectivement à l'anode de la diode D, à la gâchette du thyristor Th et à la gâchette du thyristor pilote Th1. Des régions 26 et 27 de type N correspondent respectivement aux cathodes des thyristors Th et Th1. La cathode du thyristor Th est munie de courts-circuits d'émetteur pour insensibiliser ce thyristor alors que la cathode du thyristor pilote Th1 est dépourvue de courts-circuits d'émetteur pour rendre ce thyristor très sensible. La face arrière du substrat comporte, en regard des cathodes des thyristors Th et Th1, une région 28 de type P correspondant à l'anode commune des thyristors Th et Th1 et, en regard de la région d'anode 22 de la diode D, une région 29 de type N$^+$ correspondant au contact de cathode de cette diode. La face inférieure est uniformément revêtue d'une métallisation 30. Les zones de cathode du thyristor Th et d'anode de la diode D sont revêtues d'une métallisation 31. La région de cathode 27 du thyristor Th1 est reliée à la région de gâchette 23 du thyristor Th par une métallisation 32. La résistance R est réalisée sous forme d'une région 34 de type P à faible niveau de conductivité disposée entre les régions P 23 et 24. La jonction correspondant à la diode zener Z est réalisée en prévoyant une couche 35 de type N fortement dopée à l'interface entre la région 24 et le substrat 21.

La réalisation illustrée en figure 5 présente plusieurs inconvénients. D'une part, elle nécessite, en plus des couches classiquement utilisées pour la réalisation d'un thyristor, la présence de la couche "enterrée" de type N fortement dopée 35 et surtout la présence de la région de type P faiblement dopée 34 ce qui impose d'avoir recours à des étapes supplémentaires de fabrication. D'autre part, comme on l'a indiqué précédemment, pour que la résistance entre cathode et gâchette du thyristor Th1 soit suffisante, de l'ordre de 1 à 10 kohms, il faut que la région 34 soit très faiblement dopée ce qui impose des contraintes de fabrication qui rendent le dispositif difficile à reproduire d'un lot de fabrication à un autre.

Un autre type de composant semiconducteur est décrit dans JP-A-56 055 068.

Ainsi, un objet de la présente invention est de prévoir un composant dipôle à déclenchement par retournement contrôlé en tension et en courant, la valeur du courant de déclenchement étant fixée à une valeur faible.

Un autre objet de la présente invention est de prévoir un tel composant réalisable d'une façon technologiquement simple et reproductible.

Un autre objet de la présente invention est de prévoir un tel composant dans lequel les valeurs de tension et du courant de retournement puissent être choisies indépendamment.

Pour atteindre ces objets, la présente invention telle que revendiquée dans la revendication 1 prévoit un composant dipôle à déclenchement par retournement en tension à sensibilité en retournement contrôlée, comprenant un thyristor principal dont la gâchette est connectée à l'anode par l'intermédiaire d'un thyristor pilote. Un transistor d'amorçage est disposé en parallèle sur le thyristor pilote, la base du transistor d'amorçage étant reliée à la gâchette du thyristor pilote.

Selon un mode de réalisation de la présente invention, l'émetteur du transistor d'amorçage correspond à la région de cathode du thyristor pilote et la base du transistor d'amorçage correspond à la région de gâchette du thyristor pilote.

En d'autres termes, la présente invention prévoit un composant dipôle à déclenchement par retournement en tension constitué d'un thyristor vertical à amplification de gâchette comprenant en outre une région du type de conductivité du substrat remplaçant une portion de la couche d'anode du thyristor pilote en regard d'une portion de la région de cathode de ce thyristor pilote.

Ainsi, la présente invention prévoit un composant dipôle à déclenchement par retournement en tension à sensibilité en retournement contrôlée comprenant, dans un substrat semi-conducteur, une première structure NPNP verticale correspondant à un thyristor principal, une deuxième structure NPNP verticale correspondant à un thyristor pilote, les anodes des thyristors principal et pilote correspondant à une même couche du côté de la face arrière du substrat. Une portion de la couche d'anode du thyristor pilote est remplacée par une région supplémentaire du type de conductivité du substrat, une métallisation de face arrière contactant les régions d'anode des thyristors et la région supplémentaire, une métallisation de cathode étant formée sur la cathode du thyristor principal et une métallisation de connexion reliant la cathode du thyristor pilote à la région de gâchette du thyristor principal.

Selon un mode de réalisation de la présente invention, le composant comprend en outre un prolongement de la région de gâchette du thyristor principal en vis-à-vis d'une région du même type de conductivité que le substrat pour former une diode anti-parallèle avec le thyristor principal.

Ces objets, caractéristiques et avantages ainsi que d'autres de la présente invention seront exposés en détail dans la description suivante de modes de réalisation particuliers faite, à titre non-limitatif, en relation avec les figures jointes parmi lesquelles :

les figures 1 à 5 décrites précédemment représentent respectivement :

- un circuit d'allume-gaz,
- une courbe de tension V en fonction du temps t utile à l'explication du fonctionnement du circuit de la figure 1,
- une caractéristique d'amorçage par retournement en tension d'un thyristor,
- un circuit classique d'un thyristor associé à un thyristor pilote et à un élément de déclenchement,
- une vue en coupe schématique d'un composant mettant en oeuvre le circuit de la figure 4 ;

la figure 6 représente une vue en coupe schématique d'un composant selon la présente invention ;

la figure 7 représente un schéma équivalent du circuit de la figure 6 ; et

la figure 8 représente une courbe courant-tension utile à l'explication du fonctionnement du composant de la figure 6.

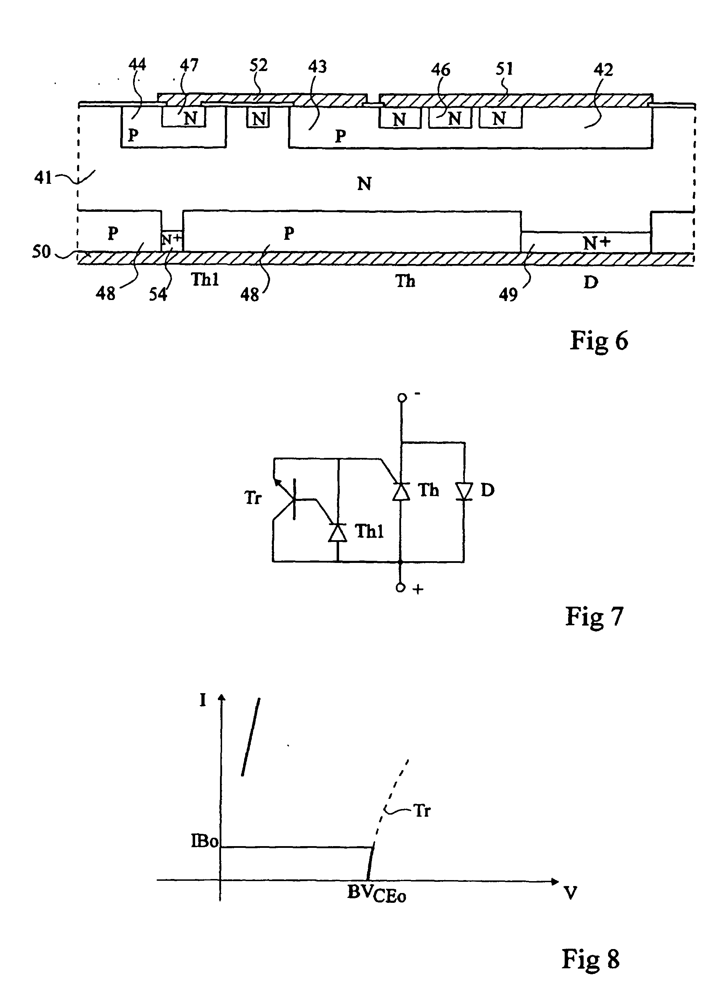

La figure 6 illustre une vue en coupe d'un composant selon la présente invention. Ce composant est pour l'essentiel identique à un composant classique de thyristor à amplication de gâchette (et à diode en anti-parallèle). Ce composant est constitué à partir d'un substrat 41 de type N faiblement dopé. Dans la face supérieure, des régions 42, 43 et 44 de type P correspondent respectivement à la région d'anode d'une diode D, à la région de gâchette d'un thyristor principal Th et à la région de gâchette d'un thyristor pilote. Dans les régions 43 et 44 sont respectivement formées des régions 46 et 47 de type N correspondant respectivement à la cathode du thyristor principal et à la cathode du thyristor pilote. La face arrière du substrat comporte une région 48 de type P en regard des régions de thyristor et une région 49 de type N en regard de la région d'anode de la diode D. La face arrière est revêtue d'une métallisation 50. Les régions de cathode 46 du thyristor Th et d'anode 42 de la diode D sont revêtues d'une métallisation 51. La région de cathode 47 du thyristor pilote Th1 est reliée à la région de base 43 du thyristor principal Th par une métallisation 52.

Le composant décrit jusqu'à présent est un thyristor à amplification de gâchette classique comprenant un thyristor principal associé à un thyristor pilote.

La seule modification qu'apporte la présente invention à cette structure classique consiste en une région de type N fortement dopée 54 disposée en regard d'une portion de la région de cathode 47 du thyristor pilote. On notera que la formation de cette région n'implique pas d'étapes supplémentaires de fabrication par rapport à la réalisation classique d'un thyristor à amplification de gâchette à diode anti-parallèle puisque cette région 54 peut être formée en même temps que la région de cathode 49 de la diode.

Toutefois, cette légère modification de structure modifie fondamentalement le fonctionnement du système. En effet, comme le représente la figure 7, la présence de la région 54 équivaut à disposer un transistor Tr en parallèle sur le thyristor Th1. L'émetteur de ce transistor correspond à la région de cathode 47 du thyristor. La base du transistor est constituée par la région 44 et est confondue avec la région de gâchette du thyristor Th1. Le collecteur du transistor correspond au substrat N et le contact sur ce collecteur est repris par la région N$^+$ 54.

A faible courant, comme le représente la figure 8, la caractéristique de l'ensemble est fixée par le transistor. Ce transistor est bloqué tant que la tension à ses bornes est inférieure à une valeur BV$_{CEO}$ qui, d'après la formule de Miller, est égale à BV$_{CBO}$/β$^{1/n}$, BV$_{CBO}$ étant la tension de claquage de la jonction collecteur/base et β étant le gain du transistor. Pour β=10 et n=4, si BV$_{CBO}$ est égal à 390 volts, on aura BV$_{CEO}$=220 volts. Ensuite seulement, une fois que le courant dans le transistor atteint une valeur I$_{BO}$, on a un retournement du thyristor. On notera que le réglage de ce courant de retournement du thyristor dépend essentiellement de la structure géométrique (dimension et forme) de la région N$^+$ 54.

La tension de retournement du dispositif est donc essentiellement fixée par la jonction entre les régions 41 et 44 qui correspond à la jonction collecteur-base du transistor Tr. La résistivité du matériau de substrat 41 sera choisie, par exemple, de l'ordre de 15 à 25 ohms (2 à 3.10$^{14}$ atomes/cm$^3$) de façon que l'on ait une tension d'avalanche de cette jonction réglée à une valeur BV$_{CBO}$, par exemple de l'ordre de 350 à 450 volts.

La présence du transistor Tr permet de plus de désensibiliser le thyristor pilote Th1 par rapport à des claquages en dV/dt.

Parmi les avantages de la présente invention on notera que :

- on obtient un réglage simple de la valeur du courant de retournement I$_{BO}$ par le choix de la surface et de la dimension de la région 54 ;
- on obtient un réglage indépendant de la tension de claquage par le choix des caractéristiques du transistor (dopage collecteur, dopage base, épaisseur de base) ; et
- le procédé de fabrication est beaucoup plus simple que celui de l'art antérieur puisque l'on évite les étapes de formation de couches supplémentaires telles que les couches 34 et 35 de la figure 5.

Bien entendu, alors que la présente invention n'a été décrite que dans le cadre de son application à un circuit d'allume-gaz, le composant selon l'invention pourra être utilisé dans toute structure où l'on désire utiliser un composant dipôle à déclenchement par retournement en tension dont la tension et le courant de retournement sont déterminés avec précision, le courant de retournement ayant une valeur faible. Par ailleurs, bien que, dans le mode de réalisation décrit, le composant soit associé à une diode anti-parallèle, il n'est pas toujours nécessaire de prévoir une telle diode.

**Revendications**

1. Composant dipôle à déclenchement par retournement en tension à sensibilité en retournement contrôlée, comprenant un thyristor principal (Th) et un thyristor pilote (Th1) dont les bornes principales sont connectées à la gâchette et à l'anode du thyristor principal,

   dans lequel les bornes principales d'un transistor d'amorçage (Tr) sont connectées aux bornes principales du thyristor pilote, la base du transistor étant reliée à la gâchette du thyristor pilote.

2. Composant selon la revendication 1, **caractérisé en ce que** l'émetteur du transistor d'amorçage correspond à la région de cathode (47) du thyristor pilote et **en ce que** la base du transistor d'amorçage correspond à la région de gâchette (44) du thyristor pilote.

3. Composant dipôle à déclenchement par retournement en tension ayant la structure d'un thyristor vertical à amplification de gâchette selon la revendication 1, **caractérisé en ce qu'**il comprend en outre une région (54) du type de conductivité du substrat, remplaçant une portion de la couche d'anode du thyristor pilote en regard d'une portion de la région de cathode de ce thyristor pilote.

4. Composant dipôle à déclenchement par retournement en tension à sensibilité en retournement contrôlée selon la revendication 3 comprenant, dans un substrat semiconducteur, une première structure NPNP verticale (46, 42, 41, 48) correspondant à un thyristor principal, une deuxième structure NPNP verticale (47, 44, 41, 48) correspondant à un thyristor pilote, les anodes des thyristors principal et pilote correspondant à une même couche (48) du côté de la face arrière du substrat, **caractérisé en ce qu'**une portion de la couche d'anode du thyristor pilote est remplacée par une région supplémentaire (54) du type de conductivité du substrat en regard d'une portion de la région de cathode de ce thyristor pilote, une métallisation de face arrière (50) contactant les régions d'anode des thyristors et ladite région supplémentaire (54), une métallisation de cathode (51) étant formée sur la cathode du thyristor principal et une métallisation de connexion (52) reliant la cathode du thyristor pilote à la région de gâchette du thyristor principal.

5. Composant selon la revendication 3 ou 4, **caractérisé en ce qu'**il comprend en outre un prolongement (42) de la région de gâchette du thyristor principal en face d'une région (49) du même type de conductivité que le substrat pour former une diode anti-parallèle avec le thyristor principal.

**Patentansprüche**

1. Dipolkomponente zur Triggerung durch eine Kippspannung mit kontrollierter Kippempfindlichkeit, welche einen Hauptthyristor (Th) und einen Steuerthyristor (Th1) umfaßt, dessen Hauptanschlüsse mit dem Gate und der Anode des Hauptthyristors verbunden sind, wobei die Hauptanschlüsse eines triggernden Transistors (Tr) mit den Hauptanschlüssen des Steuerthyristors verbunden sind, wobei die Basis des Transistors mit dem Gate des Steuerthyristors verbunden ist

2. Komponente nach Anspruch 1, **dadurch gekennzeichnet, daß** der Emitter des triggernden Transistors der Kathodenregion (47) des Steuerthyristors entspricht, und daß die Basis des triggernden Transistors der Gateregion (44) des Steuerthyristois entspricht

3. Dipolkomponente zur Triggerung durch eine Kippspannung, welche die Struktur eines vertikalen Thyristors mit Steuerverstärkung nach Anspruch 1 aufweist **dadurch gekennzeichnet, daß** sie des weiteren eine Region (54) des Leitfähigkeitstyps des Substrats umfäßt, welche einen Teil der Anodenschicht des Steuerthyristors ersetzt, welcher einem Teil der Kathodenregion des Steuerthyristors gegenübersteht.

4. Dipolkomponente zur Triggerung durch eine Kippspannung mit kontrollierter Kippempfindlichkeit nach Anspruch 3, welche in einem Halbleitersubstrat eine erste vertikale NPNP-Struktur (46, 42, 41, 48), die einem Hauptthyristor entspricht, und eine zweite vertikale NPNP-Struktur (47, 44, 41, 48), die einem Steuerthyristor entspricht, umfaßt, wobei die Anoden der Haupt- und Steuertransistoren derselben Schicht (48) auf der Rückseite des Substrats entsprechen, **dadurch gekennzeichnet, daß** ein Teil der Anodenschicht des Steuerthyristors, der einem Teil der Kathodenregion des Steuerthyristors gegenübersteht, durch eine zusätzliche Region (54) des Leitfähigkeitstyps des Substrats ersetzt ist, wobei eine Rückseitenmetallisierung (50) die Anodenregionen des Thyristors und die zusätzliche Region (54) kontaktiert, eine Kathodenmetallisierung (51) auf der Kathode des Hauptthyristors gebildet ist und eine Verbindungsmetallisierung (52) die Kathode des Steuerthyristors mit der Gateregion des Hauptthyristors verbindet.

5. Komponente nach Anspruch 3 oder 4, **dadurch gekennzeichnet, daß** sie des weiteren eine Verlängerung (42) der Gateregion des Hauptthyristors, die einer Region (49) des gleichen Leitfähigkeitstyps wie das Substrat gegenübersteht, um eine zu dem Hauptthyristor antiparallele Diode zu bilden.

**Claims**

1. A dipole component triggered by a breakover voltage and having a controlled breakover sensitivity, comprising a main thyristor (Th) having a gate connected to an anode through a pilot thyristor (Th1) the main terminals of which are connected to the gate and the anode of the main transistor, wherein the main terminals of a triggering transistor (Tr) are connected to the main terminals of the pilot thyristor, the base of the transistor being connected to the gate of the pilot thyristor.

2. The component of claim 1, **characterized in that** the emitter of the triggering transistor corresponds to the cathode region (47) of the pilot thyristor, and the base of the triggering transistor corresponds to the gate region (44) of the pilot thyristor.

3. A dipole component triggered by a breakover voltage, having the structure of a vertical amplifying-gate thyristor according to claim 1, **characterized in that** it further comprises a region (54) having the conductivity type of the substrate, and replacing a portion of the anode layer of the pilot thyristor in front of a portion of the cathode region of said pilot thyristor.

4. A dipole component triggered by a breakover voltage having a controlled breakover sensitivity according to claim 3 comprising, in a semiconductor substrate, a first vertical NPNP structure (46, 42, 41, 48) corresponding to a main thyristor, a second vertical NPNP structure (47, 44, 41, 48) corresponding to a pilot thyristor, anodes of the main and pilot thyristors corresponding to a same layer (48) on the rear surface of the substrate, **characterized in that** a portion of the anode layer of the pilot thyristor in front of a portion of a cathode region of said pilot thyristor is replaced with an additional layer (54) having a conductivity type of the substrate, a rear surface metallization (50) contacting the anode regions of the thyristors and said additional region (54), a cathode metallization (51) being formed on the cathode of the main thyristor, and a connection metallization (52) connecting the cathode of the pilot thyristor to the gate region of the main thyristor.

5. The component of claim 3 or 4, further comprising an extension (42) of the gate region of the main thyristor facing a region (49) of the same type of conductivity as the substrate to form a parallel diode, head-to-tail connected to the main thyristor.

Fig 1

Fig 2

Fig 3

Fig 4

Fig 5

Fig 6

Fig 7

Fig 8